(19) Europäisches Patentamt
European Patent Office
Office européen des brevets

(11) **EP 3 079 320 B1**

(12) **FASCICULE DE BREVET EUROPEEN**

(45) Date de publication et mention
de la délivrance du brevet:
**09.05.2018 Bulletin 2018/19**

(51) Int Cl.:
*H04L 27/12* *(2006.01)*      *H04L 27/04* *(2006.01)*
*H03B 5/12* *(2006.01)*      *H04B 1/00* *(2006.01)*

(21) Numéro de dépôt: **16164308.5**

(22) Date de dépôt: **07.04.2016**

(54) **SYSTÈME ET PROCÉDÉ D'ÉMISSION RADIOFRÉQUENCE ULTRA LARGE BANDE**

ULTRABREITBAND-FUNKFREQUENZ-AUSSTRAHLUNGSSYSTEM UND VERFAHREN

ULTRA WIDE BAND RADIOFREQUENCY TRANSMISSION SYSTEM AND METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.04.2015 FR 1553074**

(43) Date de publication de la demande:
**12.10.2016 Bulletin 2016/41**

(73) Titulaire: **COMMISSARIAT À L'ÉNERGIE
ATOMIQUE ET AUX
ÉNERGIES ALTERNATIVES
75015 Paris (FR)**

(72) Inventeurs:
• **SILIGARIS, Alexandre
38100 Grenoble (FR)**

• **DEHOS, Cédric
38210 Tullins (FR)**

(74) Mandataire: **Cabinet Beaumont
4, Place Robert Schuman
B.P. 1529
38025 Grenoble Cedex 1 (FR)**

(56) Documents cités:
**WO-A1-2008/069444      US-A1- 2004 017 841
US-A1- 2014 323 062**

• **ISKANDAR ZYAD ET AL: "A 60-GHz UWB pulse
generator with fast start-up and extinction using
injection conditions", 2014 IEEE
INTERNATIONAL CONFERENCE ON
ULTRA-WIDEBAND (ICUWB), IEEE, 1 septembre
2014 (2014-09-01), pages 390-393, XP032684123,
DOI: 10.1109/ICUWB.2014.6959013**

EP 3 079 320 B1

**Description**

Domaine

La présente demande concerne un système d'émission radiofréquence ultra large bande et un procédé d'émission radiofréquence ultra large bande.

Exposé de l'art antérieur

Un système d'émission radiofréquence fait partie d'un système de communication radiofréquence qui peut notamment être utilisé pour remplacer un système de communication par câble.

De façon générale, un système d'émission radiofréquence reçoit un signal à niveaux discrets qui contient les données utiles à émettre. A titre d'exemple, le signal à niveaux discrets correspond à un signal analogique modulé selon un codage en ligne, notamment le codage NRZ (acronyme anglais pour Non Return to Zero) et obtenu par conversion numérique-analogique d'un signal binaire. Le système d'émission radiofréquence transforme alors le signal à niveaux discrets en un signal analogique oscillant dans lequel l'information contenue dans le signal à niveaux discrets est codée. Cette étape est appelée modulation. Le système d'émission radiofréquence peut, en outre, transposer le signal analogique dans une bande de fréquences radio adaptée au canal de propagation sur lequel le signal analogique transposé en fréquence est émis.

On appelle système d'émission radiofréquence ultra large bande ou UWB (acronyme anglais pour Ultra Wide Band) un système d'émission radiofréquence pour lequel le rapport entre la largeur de bande et la fréquence centrale du signal émis est supérieure ou égale à 20 % ou pour lequel la largeur de bande du signal émis est supérieure ou égale à 250 MHz ou 500 MHz selon les pays.

Un exemple de modulation pouvant être mis en oeuvre dans un système d'émission UWB est la modulation par déplacement d'amplitude ou ASK (acronyme anglais pour Amplitude-Shift Keying) dans laquelle l'information contenue dans le signal à niveaux discrets est représentée par des variations d'amplitude d'une onde porteuse. Un cas particulier de modulation ASK est la modulation en tout ou rien ou OOK (acronyme anglais pour On-Off Keying) dans laquelle les données binaires sont représentées par la présence ou par l'absence de l'onde porteuse. Un avantage d'un procédé d'émission radiofréquence UWB mettant en oeuvre une modulation ASK est que la modulation ASK peut être appliquée directement à l'onde porteuse. Il n'y a alors pas d'étape de transposition en fréquence.

Les systèmes d'émission radiofréquence UWB connus peuvent avoir un débit de transmission de données qui est insuffisant pour certaines applications. En outre, les systèmes d'émission radiofréquence UWB connus peuvent ne pas être suffisamment robustes par rapport aux sources de perturbations du signal émis. De plus, les systèmes d'émission radiofréquence UWB connus peuvent avoir une consommation électrique excessive.

Les documents WO 2008/069444 et US 2004/017841 décrivent des systèmes d'émission radiofréquence ultra large bande.

Résumé

Un objet d'un mode de réalisation vise à pallier tout ou partie des inconvénients des systèmes d'émission radiofréquence UWB et des procédés d'émission radiofréquence UWB décrits précédemment.

Un autre objet d'un mode de réalisation est d'augmenter le débit de transmission de données du système d'émission radiofréquence UWB.

Un autre objet d'un mode de réalisation est d'augmenter la robustesse du procédé d'émission radiofréquence UWB.

Un autre objet d'un mode de réalisation est que le procédé d'émission radiofréquence UWB mette en oeuvre une modulation ASK.

Ainsi, un mode de réalisation prévoit un système d'émission radiofréquence ultra large bande adapté à recevoir un premier signal à niveaux discrets, et comprenant un oscillateur commandé en tension adapté à fournir un premier signal oscillant comportant un circuit oscillant alimenté par un circuit d'alimentation comportant au moins une première source de courant commandée par le premier signal à niveaux discrets ou un deuxième signal à niveaux discrets obtenu à partir du premier signal à niveaux discrets ; un mélangeur adapté à recevoir le premier signal oscillant et à fournir un deuxième signal oscillant égal au premier signal oscillant multiplié par un gain qui dépend du premier signal à niveaux discrets ou d'un troisième signal à niveaux discrets obtenu à partir du premier signal à niveaux discrets ; et une antenne ou un dispositif de couplage électromagnétique adapté à émettre un signal radiofréquence à partir du deuxième signal oscillant.

Selon un mode de réalisation, l'oscillateur commandé en tension est adapté à fournir le premier signal oscillant à une première fréquence d'oscillation lorsque le premier signal à niveaux discrets ou le deuxième signal à niveaux discrets est à un premier état et à fournir le premier signal oscillant à une deuxième fréquence d'oscillation, différente de la première fréquence d'oscillation, lorsque le premier signal à niveaux discrets ou le deuxième signal à niveaux discrets est à un deuxième état.

Selon un mode de réalisation, la première source de courant est activée lorsque le premier signal à niveaux discrets ou le deuxième signal à niveaux discrets est au premier état et est désactivée lorsque le premier signal à niveaux discrets ou le deuxième signal à niveaux discrets est au deuxième état.

Selon un mode de réalisation, le circuit d'alimentation comporte une deuxième source de courant activée en permanence en parallèle de la première source de courant.

Selon un mode de réalisation, le système d'émission radiofréquence comprend un module de conversion série/parallèle adapté à recevoir le premier signal à niveaux discrets à une première fréquence et adapté à fournir au moins des quatrième et cinquième signaux à niveaux discrets à une deuxième fréquence inférieure à la première fréquence et comprenant un module de logique combinatoire adapté à recevoir les quatrième et cinquième signaux à niveaux discrets et adapté à fournir le deuxième signal à niveaux discrets et le troisième signal à niveaux discrets.

Selon un mode de réalisation, le mélangeur comprend un amplificateur à transconductance adapté à recevoir le premier signal oscillant et comprenant une sortie reliée à un noeud, adapté à fournir le deuxième signal oscillant, par au moins un premier interrupteur commandé par le premier signal à niveaux discrets ou le troisième signal à niveaux discrets.

Selon un mode de réalisation, le mélangeur comprend au moins un deuxième interrupteur monté en parallèle du premier interrupteur et commandé par un sixième signal à niveaux discrets obtenu à partir du premier signal à niveaux discrets.

Selon un mode de réalisation, le mélangeur comprend au moins un troisième interrupteur monté en parallèle du premier interrupteur et commandé par un signal de commande analogique constant.

Un mode de réalisation prévoit un procédé d'émission radiofréquence ultra large bande comprenant les étapes consistant à recevoir un premier signal à niveaux discrets ; fournir un premier signal oscillant par un oscillateur commandé en tension comportant un circuit oscillant alimenté par un circuit d'alimentation comportant au moins une première source de courant commandée par le premier signal à niveaux discrets ou un deuxième signal à niveaux discrets obtenu à partir du premier signal à niveaux discrets ; fournir un deuxième signal oscillant, par un mélangeur, égal au premier signal oscillant multiplié par un gain qui dépend du premier signal à niveaux discrets ou d'un troisième signal à niveaux discrets obtenu à partir du premier signal à niveaux discrets ; et émettre un signal radiofréquence à partir du deuxième signal oscillant par une antenne ou un dispositif de couplage électromagnétique.

Selon un mode de réalisation, l'oscillateur commandé en tension fournit le premier signal oscillant à une première fréquence d'oscillation lorsque le premier signal à niveaux discrets ou le deuxième signal à niveaux discrets est à un premier état et fournit le premier signal oscillant à une deuxième fréquence d'oscillation, différente de la première fréquence d'oscillation, lorsque le premier signal à niveaux discrets ou le deuxième signal à niveaux discrets est à un deuxième état.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de façon partielle et schématique, un mode de réalisation d'un système d'émission radiofréquence UWB mettant en oeuvre une modulation FSK et ASK ;
la figure 2 est un chronogramme de signaux utilisés par le système d'émission radiofréquence de la figure 1 ;
les figures 3 et 4 représentent des schémas électriques plus détaillés de deux modes de réalisation d'une partie du système d'émission radiofréquence de la figure 1 ;
la figure 5 représente un schéma électrique plus détaillé d'un mode de réalisation d'une autre partie du système d'émission radiofréquence de la figure 1 ;
la figure 6 représente une courbe d'évolution du rapport de modulation d'amplitude du système d'émission radiofréquence de la figure 1 en fonction d'un signal utilisé par le système d'émission radiofréquence ;
la figure 7 représente, de façon partielle et schématique, un mode de réalisation d'un système de réception radiofréquence adapté à recevoir un signal émis par le système d'émission radiofréquence de la figure 1 ;
la figure 8 représente, de façon partielle et schématique, un autre mode de réalisation d'un système d'émission radiofréquence UWB mettant en oeuvre une modulation FSK et ASK ;
la figure 9 représente un schéma électrique plus détaillé d'un mode de réalisation d'une partie du système d'émission radiofréquence de la figure 8 ;
la figure 10 est un chronogramme de signaux utilisés par le système d'émission radiofréquence de la figure 8 ; et
la figure 11 représente, de façon partielle et schématique, un autre mode de réalisation d'un système d'émission radiofréquence UWB mettant en oeuvre une modulation FSK et ASK.

Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. Sauf précision contraire, les expressions "approximativement", "sensiblement", et "de l'ordre de" signifient à 10 % près, de préférence à 5 % près. De plus, on appelle "signal à niveaux discrets" un signal qui ne peut rester constant qu'à certaines valeurs discrètes. A titre d'exemple, on appelle "signal à deux niveaux" un signal qui alterne entre un premier état constant, par exemple un état bas, noté "0", et un deuxième état constant, par exemple un état haut, noté "1". Un exemple d'un signal à deux niveaux est un signal analogique modulé selon un codage en ligne, notamment un codage RZ (acronyme anglais pour Return to Zero), un codage NRZ, un codage PPM (acronyme anglais pour Pulse Position Modulation), etc. Un autre exemple d'un signal à deux niveaux est un signal numérique binaire. Les états haut et bas de signaux à deux niveaux d'un même circuit électronique peuvent être différents. En pratique, les signaux à deux niveaux peuvent correspondre à des tensions ou à des courants qui peuvent ne pas être parfaitement constants à l'état haut ou bas. A titre d'exemple, dans le cas d'un circuit couplé entre une source d'un potentiel d'alimentation haut VDD et une source d'un potentiel de référence GND, par exemple la masse, l'état "1" d'un signal à deux niveaux du circuit peut correspondre au potentiel d'alimentation haut et l'état "0" d'un signal à deux niveaux du circuit peut correspondre au potentiel de référence.

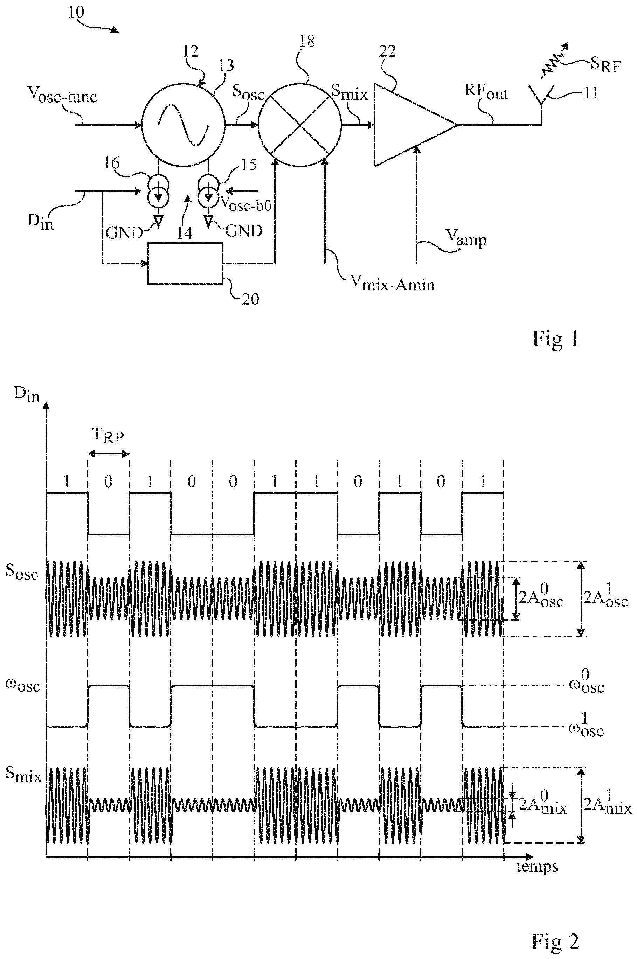

La figure 1 représente un mode de réalisation d'un système d'émission radiofréquence UWB 10.

Le système d'émission radiofréquence 10 reçoit un signal à niveaux discrets $D_{in}$, par exemple un signal à deux niveaux, cadencé à une fréquence F et contenant les données utiles à transmettre. Le système 10 émet un signal radiofréquence $S_{RF}$ par une antenne d'émission 11. A titre d'exemple, la fréquence du signal $S_{RF}$ peut être comprise entre 57 GHz et 66 GHz. Selon un autre mode de réalisation, l'antenne 11 peut être remplacée par un dispositif de couplage électromagnétique.

Le système d'émission radiofréquence 10 comprend un oscillateur commandé en tension 12 ou VCO (acronyme anglais pour Voltage Controled Oscillator). Le VCO 12 comprend un circuit oscillant 13 alimenté en courant par un circuit d'alimentation 14. Le circuit oscillant 13 reçoit un signal de commande $V_{osc\text{-}tune}$ et fournit un signal analogique oscillant $S_{osc}$. Le circuit d'alimentation 14 comprend une première source de courant 15 qui est commandée par un signal $V_{osc\text{-}b0}$ et une deuxième source de courant 16 qui est commandée par le signal $D_{in}$. A titre d'exemple, chaque source de courant 15, 16 comprend une borne reliée au circuit oscillant 13 et une borne reliée à une source d'un potentiel de référence GND, par exemple la masse.

Le système d'émission radiofréquence 10 comprend, en outre, un mélangeur ou un interrupteur 18 qui reçoit les signaux $S_{osc}$ et $D_{in}$ et un signal de commande $V_{mix\text{-}Amin}$ et qui fournit un signal analogique oscillant $S_{mix}$. Le système 10 peut, en outre, comprendre un module de temporisation 20 retardant le signal $D_{in}$ fourni au mélangeur 18 par rapport au signal $D_{in}$ fourni à la source de courant 16 pour tenir compte du temps de réponse du VCO 12. Toutefois, dans le cas où le temps de réponse du VCO 12 est faible par rapport à la période du signal $D_{in}$, le module de temporisation 20 peut ne pas être présent.

Selon un mode de réalisation, le système d'émission radiofréquence 10 comprend, en outre, un amplificateur 22 commandé par un signal de commande $V_{amp}$. L'amplificateur 22 reçoit le signal $S_{mix}$ et fournit un signal $RF_{out}$ amplifié qui est fourni à l'antenne 11 pour l'émission du signal radiofréquence $S_{RF}$. A titre de variante, l'amplificateur 22 peut ne pas être présent dans le cas où le signal $S_{mix}$ a une puissance suffisante pour être émis directement par l'antenne 11.

Le signal $D_{in}$ contient les données utiles à transmettre. Le signal $D_{in}$ peut être un signal binaire.

De façon classique, l'oscillateur VCO 12 fournit un signal analogique oscillant, par exemple un signal sinusoïdal, dont la fréquence dépend du signal $V_{osc\text{-}tune}$. Toutefois, selon un mode de réalisation, le signal $V_{osc\text{-}tune}$ est maintenu constant et l'amplitude et la fréquence du signal $S_{osc}$ fourni par l'oscillateur VCO 12 sont modifiées en faisant varier l'intensité du courant d'alimentation du circuit oscillant 13 fourni par le circuit d'alimentation 14. Selon un mode de réalisation, la source de courant 15 est activée en permanence, le signal de commande $V_{osc\text{-}b0}$ étant maintenu constant. La source de courant 16 est activée lorsque le signal $D_{in}$ est à "1" et est désactivée lorsque le signal $D_{in}$ est à "0". L'intensité du courant alimentant le circuit oscillant 13, lorsque les sources de courant 15 et 16 sont activées, est supérieure à l'intensité du courant alimentant le circuit oscillant 13 lorsque seule la source de courant 15 est activée.

Le signal $S_{osc}$ est un signal oscillant, par exemple un signal sinusoïdal, ayant une pulsation $\omega_{osc}$ et une amplitude $A_{osc}$. Lorsque le signal $D_{in}$ est à "0", la pulsation $\omega_{osc}$ du signal $S_{osc}$ est égale à $\omega_{osc}^{0}$ et l'amplitude $A_{osc}$ du signal $S_{osc}$ est égale à $A_{osc}^{0}$. Lorsque le signal $D_{in}$ est à "1", la pulsation $\omega_{osc}$ du signal $S_{osc}$ est égale à $\omega_{osc}^{1}$ et l'amplitude

$A_{osc}$ du signal $S_{osc}$ est égale à $A_{osc}^1 \cdot$ Le signal $S_{osc}$ fourni par l'oscillateur 12 suit donc les relations (1) suivantes :

$$S_{osc} = \begin{cases} S_{osc}^1 = A_{osc}^1 \cos(\omega_{osc}^1 t), & D_{in} = "1" \\ S_{osc}^0 = A_{osc}^0 \cos(\omega_{osc}^0 t), & D_{in} = "0" \end{cases} \qquad (1)$$

Le mélangeur 18 multiplie le signal $S_{osc}$ avec un gain de mélange $G_{mix}$ qui dépend des signaux $D_{in}$ et $V_{mix-Amin}$ et qui peut prendre l'une ou l'autre des valeurs $G_{mix}^0$ et $G_{mix}^1 \cdot$ Le signal $S_{mix}$ a la même pulsation $\omega_{osc}$ que le signal $S_{osc}$. Lorsque le signal $D_{in}$ est à "0", la pulsation $\omega_{osc}$ du signal $S_{mix}$ est égale à $\omega_{osc}^0$ et l'amplitude $A_{mix}$ du signal $S_{mix}$ est égale à $A_{mix}^0 \cdot$ Lorsque le signal $D_{in}$ est à "1", la pulsation $\omega_{osc}$ du signal $S_{mix}$ est égale à $\omega_{osc}^1$ et l'amplitude $A_{mix}$ du signal $S_{mix}$ est égale à $A_{mix}^1 \cdot$ Plus précisément, le signal $S_{mix}$ fourni par le mélangeur 18 suit les relations (2) suivantes :

$$S_{mix} = \begin{cases} S_{osc}^1 \cdot G_{mix}^1 = G_{mix}^1 \cdot A_{osc}^1 \cos(\omega_{osc}^1 t) = A_{mix}^1 \cos(\omega_{osc}^1 t), & D_{in} = "1" \\ S_{osc}^0 \cdot G_{mix}^0 = G_{mix}^0 \cdot A_{osc}^0 \cos(\omega_{osc}^0 t) = A_{mix}^0 \cos(\omega_{osc}^0 t), & D_{in} = "0" \end{cases} \qquad (2)$$

Le signal $S_{mix}$ est donc modulé simultanément en amplitude et en fréquence. La modulation en fréquence, ou modulation FSK (acronyme anglais pour Frequency Shift Keying) est réalisée par l'oscillateur 12 et le rapport de modulation d'amplitude est imposé par le mélangeur 18. Le rapport de modulation d'amplitude est donc fixé indépendamment du rapport de modulation de fréquence.

La figure 2 représente un exemple de chronogramme du signal binaire $D_{in}$, du signal analogique $S_{osc}$, de la pulsation $\omega_{osc}$ et du signal analogique $S_{mix}$ dans le cas où la séquence de données binaires à transmettre est "10100110101".

A titre d'exemple, le système d'émission radiofréquence 10 peut, avec un système de réception radiofréquence, être utilisé pour le remplacement d'une liaison câblée.

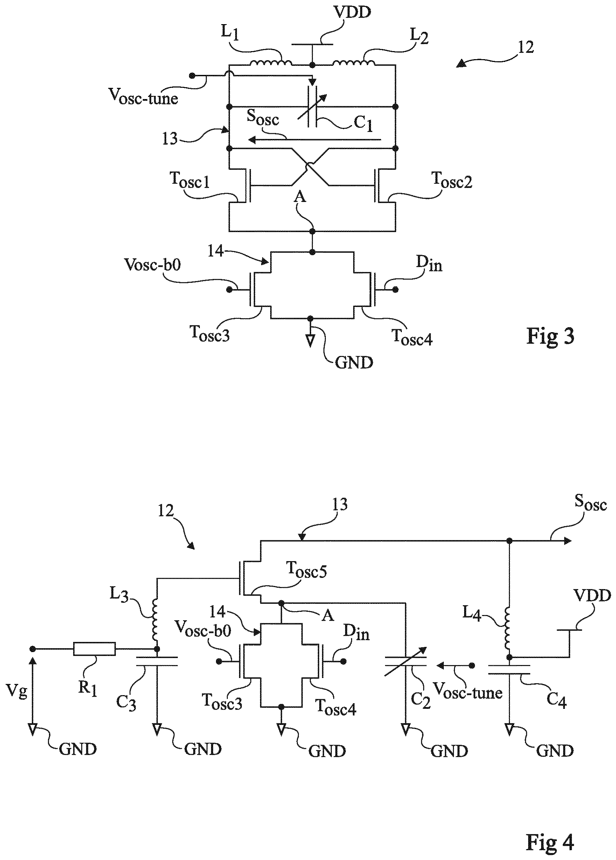

La figure 3 représente un mode de réalisation de l'oscillateur VCO 12. Le circuit oscillant 13 comprend un premier transistor MOS $T_{osc1}$ à canal N dont le drain est relié à une source d'un potentiel d'alimentation haut VDD par l'intermédiaire d'une inductance $L_1$ et dont la source est reliée à un noeud A. Le circuit oscillant 13 comprend, en outre, un deuxième transistor MOS $T_{osc2}$ à canal N dont le drain est relié à la source du potentiel d'alimentation haut VDD par l'intermédiaire d'une inductance $L_2$ et dont la source est reliée au noeud A. La grille du transistor $T_{osc1}$ est reliée au drain du transistor $T_{osc2}$. La grille du transistor $T_{osc2}$ est reliée au drain du transistor $T_{osc1}$. Le circuit oscillant 13 comprend, en outre, un condensateur $C_1$ à capacité variable, dont la capacité est commandée par le signal $V_{osc-tune}$, monté entre les drains des transistors $T_{osc1}$ et $T_{osc2}$. Le signal $S_{osc}$ correspond à la tension entre les drains des transistors $T_{osc1}$ et $T_{osc2}$.

Le circuit d'alimentation 14 comprend un troisième transistor MOS $T_{osc3}$ à canal N dont le drain est relié au noeud A, dont la source est reliée à la masse GND et dont la grille reçoit le signal $V_{osc-b0}$. Le circuit d'alimentation comprend, en outre, un quatrième transistor MOS $T_{osc4}$ à canal N dont le drain est relié au noeud A, dont la source est reliée à la masse GND et dont la grille reçoit le signal $D_{in}$.

En fonctionnement, le signal $V_{osc-tune}$ est constant et le signal $V_{osc-b0}$ est égal à "1". Le transistor $T_{osc3}$ est donc passant en permanence. Le signal $D_{in}$ peut être égal à "0" ou "1". Lorsque le signal $D_{in}$ est à "0", le transistor $T_{osc4}$ est bloqué et l'intensité du courant fourni par le circuit d'alimentation 14 est imposée par le transistor $T_{osc3}$. L'amplitude $A_{osc}$ du signal $S_{osc}$ est alors égale à $A_{osc}^0 \cdot$ Lorsque le signal $D_{in}$ est à "1", les transistors $T_{osc3}$ et $T_{osc4}$ sont passants et l'intensité du courant fourni par le circuit d'alimentation 14 est plus élevée. L'amplitude $A_{osc}$ du signal $S_{osc}$ est alors égale à $A_{osc}^1 \cdot$

La valeur nominale de la pulsation $\omega_{osc}$ est imposée notamment par la conception du circuit oscillant 13 et par la valeur du signal $V_{osc-tune}$. La différence entre les valeurs $\omega_{osc}^0$ et $\omega_{osc}^1$ de la pulsation lorsque le signal $D_{in}$ est respectivement égal à "0" et "1" provient de la variation de capacités dans le circuit oscillant 13 lorsque l'intensité du courant d'alimentation du circuit oscillant 13 varie.

La figure 4 représente un autre mode de réalisation de l'oscillateur VCO 12 dans lequel le circuit d'alimentation 14 a la même structure que celle représentée en figure 3 et dans lequel le circuit oscillant 13 comprend un transistor MOS $T_{osc5}$ à canal N dont la source est reliée au noeud A et dont le drain fournit le signal $S_{osc}$. Le noeud A est relié, en outre, à la masse GND par un condensateur $C_2$ à capacité variable, dont la capacité est commandée par le signal $V_{osc\text{-}tune}$. La grille du transistor $T_{osc5}$ est reliée à la masse GND par l'intermédiaire d'une inductance $L_3$ en série avec un condensateur $C_3$. Le point milieu entre l'inductance $L_3$ et le condensateur $C_3$ est relié à une source d'une tension de commande $V_g$ par l'intermédiaire d'une résistance $R_1$. Le drain du transistor $T_{osc5}$ est relié à la masse GND par l'intermédiaire d'une inductance $L_4$ en série avec un condensateur $C_4$. Le point milieu entre l'inductance $L_4$ et le condensateur $C_4$ est relié à la source du potentiel d'alimentation haut VDD.

Les figures 3 et 4 représentent des modes de réalisation particuliers de l'oscillateur VCO 12. Toutefois, il est clair que l'oscillateur 12 peut correspondre à tout type d'oscillateur commandé en tension comprenant un circuit oscillant alimenté par un circuit d'alimentation et pour lequel l'intensité du courant fourni par le circuit d'alimentation est susceptible d'être commandée par un signal binaire.

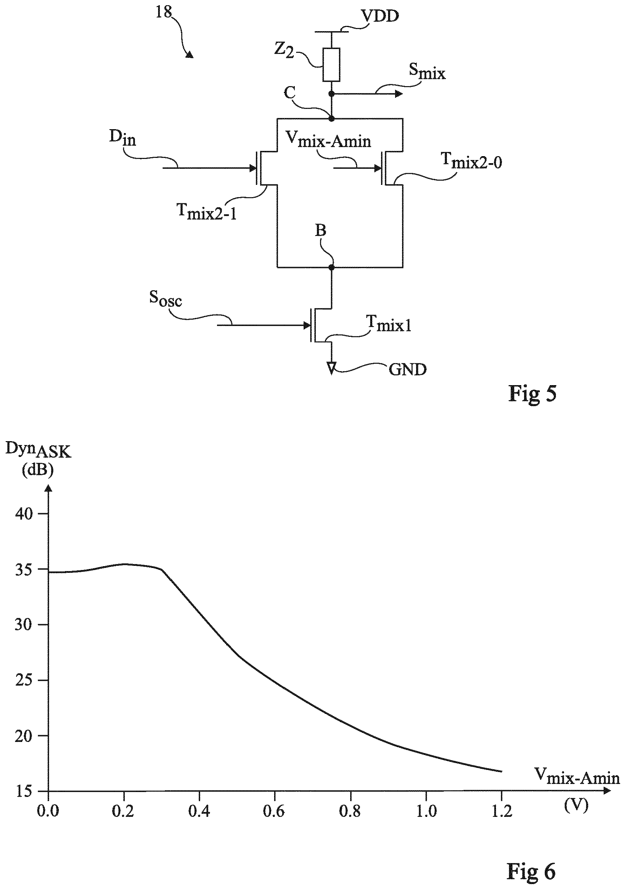

La figure 5 représente un mode de réalisation du mélangeur 18. Le mélangeur 18 comprend un transistor MOS $T_{mix1}$ à canal N dont la source est reliée à la masse GND, dont le drain est relié à un noeud B et dont la grille reçoit le signal oscillant $S_{osc}$. Le mélangeur 18 comprend, en outre, des transistors MOS $T_{mix2\text{-}0}$ et $T_{mix2\text{-}1}$, à canal N, montés en parallèle entre le noeud B et un noeud C. La grille du transistor $T_{mix2\text{-}1}$ reçoit le signal binaire $D_{in}$ et la grille du transistor $T_{mix2\text{-}0}$ reçoit un signal $V_{mix\text{-}Amin}$. Le noeud C est, en outre, relié à la source du potentiel haut VDD par une charge d'impédance $Z_2$. Le signal $S_{mix}$ correspond à la tension entre le noeud C et la masse GND.

Le transistor $T_{mix1}$ joue le rôle d'un amplificateur à transconductance tandis que les transistors $T_{mix2\text{-}0}$ et $T_{mix2\text{-}1}$ fonctionnent comme interrupteurs. En fonctionnement, le signal $V_{mix\text{-}Amin}$ est maintenu constant. Le transistor $T_{mix2\text{-}0}$ est donc passant en permanence. Le signal $D_{in}$ peut être égal à "0" ou "1". Lorsque le signal $D_{in}$ est à "0", le transistor $T_{mix2\text{-}1}$ est bloqué et le gain de mélange $G_{mix}$ est égal à $G_{mix}^0$. Lorsque le signal $D_{in}$ est à "1", les transistors $T_{mix2\text{-}0}$ et $T_{mix2\text{-}1}$ sont passants et le gain de mélange $G_{mix}$ est égal à $G_{mix}^1$.

Etant donné que les transistors $T_{mix2\text{-}0}$ et $T_{mix2\text{-}1}$ sont montés en parallèle, le gain de mélange $G_{mix}$ peut s'exprimer selon les relations (3) suivantes :

$$G_{mix} = \begin{cases} G_{mix}^1 = G_{T_{mix2\text{-}0}}^{V_{mix\text{-}Amin}} + G_{T_{mix2\text{-}1}}^1, & D_{in} = "1" \\ G_{mix}^0 = G_{T_{mix2\text{-}0}}^{V_{mix\text{-}Amin}}, & D_{in} = "0" \end{cases} \qquad (3)$$

Le signal $S_{mix}$ est donc défini par les relations (4) suivantes :

$$A_{mix} = \begin{cases} A_{mix}^1 = \left( G_{T_{mix2\text{-}0}}^{V_{mix\text{-}Amin}} + G_{T_{mix2\text{-}1}}^1 \right).A_{osc}^1, & D_{in} = "1" \\ A_{mix}^0 = G_{T_{mix2\text{-}0}}^{V_{mix\text{-}Amin}}.A_{osc}^0, & D_{in} = "0" \end{cases} \qquad (4)$$

$$\omega_{osc} = \begin{cases} \omega_{osc}^1, & D_{in} = "1" \\ \omega_{osc}^0, & D_{in} = "0" \end{cases}$$

Le rapport de modulation $Dyn_{ASK}$ de la modulation d'amplitude mise en oeuvre par le système d'émission radiofréquence 10 est donné par la relation (5) suivante :

$$Dyn_{ASK} = \frac{A_{osc}^1}{A_{osc}^0} \cdot \left( 1 + \frac{G_{T_{mix2\text{-}1}}^1}{G_{T_{mix2\text{-}0}}^{V_{mix\text{-}Amin}}} \right) \qquad (5)$$

Le rapport de modulation $Dyn_{ASK}$ peut être modifié indépendamment de la modulation FSK réalisée par l'oscillateur 18. En particulier, en faisant varier la tension $V_{mix-Amin}$, les propriétés de conduction du transistor $T_{mix2-0}$ peuvent être modifiées, ce qui permet de faire varier le rapport de modulation $Dyn_{ASK}$.

La figure 6 représente un exemple de courbe d'évolution du rapport de modulation $Dyn_{ASK}$ en fonction de la tension $V_{mix-Amin}$.

Par rapport à un système d'émission comprenant un VCO fournissant en permanence un signal oscillant au travers d'un interrupteur qui est commandé pour la réalisation d'une modulation OOK, la consommation électrique du système d'émission radiofréquence 10 représenté en figure 1 est réduite puisque l'intensité du courant consommé par l'oscillateur 12 varie avec l'amplitude du signal $S_{osc}$.

Selon un mode de réalisation, le signal émis par le système d'émission radiofréquence 10 peut être reçu par un système de réception radiofréquence adapté à réaliser une démodulation en amplitude.

Selon un mode de réalisation, le signal émis par le système d'émission radiofréquence 10 peut être reçu par un système de réception radiofréquence adapté à réaliser une démodulation en fréquence.

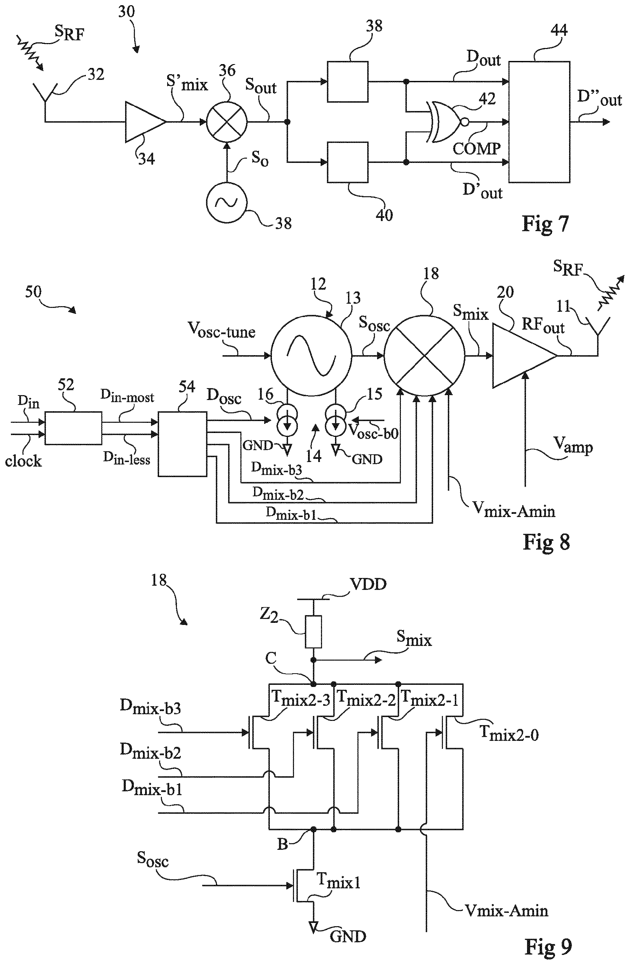

La figure 7 représente un mode de réalisation d'un système de réception radiofréquence 30 recevant le signal émis par le système d'émission radiofréquence 10 et adapté à réaliser simultanément une démodulation en fréquence et une démodulation en amplitude. Le système de réception radiofréquence 30 comprend une antenne de réception 32 recevant le signal radiofréquence $S_{RF}$ et reliée à un amplificateur faible bruit 34 qui fournit un signal oscillant $S'_{mix}$ à un mélangeur 36. Le signal $S'_{mix}$ correspond sensiblement au signal $S_{mix}$ décrit précédemment qui peut avoir été modifié par diverses sources de perturbations lors de la propagation du signal émis par le système d'émission radiofréquence 10. Le mélangeur 36 reçoit, en outre, un signal oscillant $S_O$ fourni par un oscillateur 38 qui est mélangé au signal $S'_{mix}$ pour fournir un signal $S_{out}$ en bande de base, éventuellement après filtrage. Le signal $S_{out}$ est fourni à un premier module de traitement 38 adapté à mettre en oeuvre une démodulation en amplitude et qui fournit un signal binaire $D_{out}$. Le signal $S_{out}$ est, en outre, fourni à un deuxième module de traitement 40 adapté à mettre en oeuvre une démodulation en fréquence et qui fournit un signal binaire $D'_{out}$.

Le système de réception radiofréquence 30 peut comparer les signaux binaires $D_{out}$ et $D'_{out}$ pour déterminer si le signal radiofréquence $S_{RF}$ reçu par l'antenne 32 a été modifié au cours de sa transmission. A titre d'exemple, le système de réception radiofréquence 30 peut comprendre un bloc logique de type "OU exclusif" 42 qui fournit un signal binaire COMP à l'état "0" si les signaux binaires $D_{out}$ et $D'_{out}$ sont identiques et qui fournit le signal binaire COMP à l'état "1" si les signaux binaires $D_{out}$ et $D'_{out}$ sont différents. Les signaux $D_{out}$, $D'_{out}$ et COMP peuvent être transmis à un module de correction 44 qui peut fournir un signal binaire $D''_{out}$ corrigé.

La mise en oeuvre simultanément d'une modulation en amplitude et d'une modulation en fréquence par le système d'émission radiofréquence 10 permet, de façon avantageuse, d'augmenter la robustesse de la transmission puisque le système de réception radiofréquence 30 peut mettre en oeuvre un procédé de correction spécifique tirant parti de cette modulation double, en plus d'éventuels autres procédés de correction propres à chaque type de modulation. En outre, le fait que la modulation FSK soit réalisée par le VCO 12 et que la modulation ASK soit réalisée, pour l'essentiel, par le mélangeur 18 permet de répartir les contraintes de conception du système d'émission radiofréquence 10 sur ces deux éléments. De ce fait, chacun de ces éléments peut être optimisé séparément, ce qui permet d'augmenter le débit de transmission du signal $D_{in}$.

De plus, même si le rapport de modulation de la modulation ASK réalisée par le système d'émission radiofréquence 10 est commandé par les propriétés du mélangeur 18, deux étapes de modulation d'amplitude sont en fait réalisées par le système 10, la première par l'oscillateur 12 (par la coopération du circuit oscillant 13 et du circuit d'alimentation 14), et la deuxième par le mélangeur 18. Ceci permet, de façon avantageuse, d'obtenir des fronts de transition entre deux niveaux de modulation d'amplitude qui sont plus abrupts que ceux qui seraient obtenus si une seule étape de modulation d'amplitude était mise en oeuvre. En effet, une modulation d'amplitude consiste à multiplier un signal oscillant par un signal modulant dont les fronts de transition, dans le présent mode de réalisation, correspondent aux fronts de transition d'un transistor MOS entre les états bloqué et passant. Le fait de réaliser deux étapes de modulation revient à multiplier deux fois le signal oscillant par un tel signal modulant et donc à raccourcir la transition entre deux niveaux de modulation d'amplitude.

En outre, la source de courant 15 est, de préférence, activée en permanence. Ceci permet d'assurer que l'oscillateur 12 est en fonctionnement en permanence, même s'il consomme moins lorsque seule la source de courant 15 est activée. De ce fait, lorsque la source de courant 16 passe de l'état désactivé à l'état activé, l'oscillateur 12 est déjà en fonctionnement et réagit plus rapidement que s'il était à l'arrêt.

La figure 8 représente un autre mode de réalisation d'un système d'émission radiofréquence UWB 50 adapté à fonctionner à un débit de transmission plus élevé que le système d'émission radiofréquence 10.

Le système d'émission radiofréquence 50 comprend l'ensemble des éléments du système d'émission radiofréquence 10 à la différence que le VCO 12 et le mélangeur 18 ne sont pas commandés directement par le signal $D_{in}$. Le système d'émission radiofréquence 50 comprend un module 52 de conversion série/parallèle qui reçoit un signal d'horloge clock de fréquence $2F_{RP}$ et de période $T_{RP}/2$ et le signal binaire $D_{in}$ cadencé à la fréquence $2F_{RP}$ et qui fournit

deux signaux binaires $D_{in\text{-}most}$ et $D_{in\text{-}less}$ en phase et cadencés chacun à la fréquence $F_{RP}$. Les signaux binaires $D_{in\text{-}most}$ et $D_{in\text{-}less}$ peuvent être déterminés de la façon suivante : lorsque le signal $D_{in}$ est successivement à une première valeur pendant une durée $T_{RP}/2$ et à une deuxième valeur pendant une durée $T_{RP}/2$, le signal $D_{in\text{-}most}$ est mis à la première valeur pendant une période $T_{RP}$ et le signal $D_{in\text{-}less}$ est mis simultanément à la deuxième valeur pendant la même période $T_{RP}$.

Le système d'émission radiofréquence 50 comprend, en outre, un module de logique combinatoire 54 recevant les signaux binaires $D_{in\text{-}most}$ et $D_{in\text{-}less}$ et fournissant des signaux binaires $D_{osc}$, $D_{mix\text{-}b1}$, $D_{mix\text{-}b2}$ et $D_{mix\text{-}b3}$ en phase et cadencés chacun à la fréquence $F_{RP}$.

Le système d'émission radiofréquence 50 peut, en outre, comprendre des modules de temporisation, analogues au module 20 décrit précédemment, pour chaque signal $D_{osc}$, $D_{mix\text{-}b1}$, $D_{mix\text{-}b2}$ et $D_{mix\text{-}b3}$.

Selon un mode de réalisation, la table de vérité du module 54 est la suivante :

| $D_{in\text{-}most}$ | $D_{in\text{-}less}$ | $D_{osc}$ | $D_{mix\text{-}b3}$ | $D_{mix\text{-}b2}$ | $D_{mix\text{-}b1}$ |
|---|---|---|---|---|---|
| 0 | 0 | 0 | 0 | 0 | 0 |
| 0 | 1 | 0 | 0 | 0 | 1 |
| 1 | 0 | 1 | 0 | 1 | 1 |
| 1 | 1 | 1 | 1 | 1 | 1 |

Selon un mode de réalisation, la source de courant 16 du VCO 12 est commandée par le signal $D_{osc}$ et le mélangeur 18 est commandé par les signaux $D_{mix\text{-}b1}$, $D_{mix\text{-}b2}$ et $D_{mix\text{-}b3}$.

Selon un mode de réalisation, le signal $S_{mix}$ est modulé sur quatre niveaux d'amplitude et deux niveaux de fréquence. Chaque niveau d'amplitude du signal $S_{mix}$ est associé à un symbole "00", "01", "10" ou "11" composé de la succession de deux valeurs du signal binaire $D_{in}$.

Lorsque le signal $D_{in\text{-}most}$ est à "0", quelle que soit la valeur du signal $D_{in\text{-}less}$, la pulsation $\omega_{osc}$ du signal $S_{osc}$ est égale à $\omega_{osc}^0$ et l'amplitude $A_{osc}$ du signal $S_{osc}$ est égale à $A_{osc}^0$. Lorsque le signal $D_{in\text{-}most}$ est à "1", quelle que soit la valeur du signal $D_{in\text{-}less}$, la pulsation $\omega_{osc}$ du signal $S_{osc}$ est égale à $\omega_{osc}^1$ et l'amplitude $A_{osc}$ du signal $S_{osc}$ est égale à $A_{osc}^1$. Le signal $S_{osc}$ fourni par l'oscillateur 12 suit donc la relation (6) suivante :

$$S_{osc} = \begin{cases} S_{osc}^1 = A_{osc}^1 \cos(\omega_{osc}^1 t), & D_{in\text{-}most} = "1" \\ S_{osc}^0 = A_{osc}^0 \cos(\omega_{osc}^0 t), & D_{in\text{-}most} = "0" \end{cases} \qquad (6)$$

Le mélangeur 18 multiplie le signal $S_{osc}$ avec un gain de mélange $G_{mix}$ dont la valeur dépend des signaux $D_{mix\text{-}b1}$, $D_{mix\text{-}b2}$ et $D_{mix\text{-}b3}$ et $V_{mix\text{-}Amin}$ et peut prendre quatre valeurs $G_{mix}^{ij}$ où i correspond à $D_{in\text{-}less}$ et j correspond à $D_{in\text{-}most}$.

Le signal $S_{mix}$ fourni par le mélangeur 18 suit les relations (7) suivantes :

$$S_{mix} = \begin{cases} G_{mix}^{01} S_{osc}^1 = G_{mix}^{01} \cdot A_{osc}^1 \cos(\omega_{osc}^1 t) = A_{mix}^{01} \cos(\omega_{osc}^1 t), & D_{in\text{-}less} = "0", D_{in\text{-}most} = "1" \\ G_{mix}^{11} S_{osc}^1 = G_{mix}^{11} \cdot A_{osc}^1 \cos(\omega_{osc}^1 t) = A_{mix}^{11} \cos(\omega_{osc}^1 t), & D_{in\text{-}less} = "1", D_{in\text{-}most} = "1" \\ G_{mix}^{00} S_{osc}^0 = G_{mix}^{00} \cdot A_{osc}^0 \cos(\omega_{osc}^0 t) = A_{mix}^{00} \cos(\omega_{osc}^0 t), & D_{in\text{-}less} = "0", D_{in\text{-}most} = "0" \\ G_{mix}^{10} S_{osc}^0 = G_{mix}^{10} \cdot A_{osc}^0 \cos(\omega_{osc}^0 t) = A_{mix}^{10} \cos(\omega_{osc}^0 t), & D_{in\text{-}less} = "1", D_{in\text{-}most} = "0" \end{cases}$$

La figure 9 représente un mode de réalisation du mélangeur 18 adapté au système d'émission 50 représenté en figure 8. Le mélangeur 18 comprend l'ensemble des éléments représentés en figure 5 à la différence que la grille du transistor $T_{mix2\text{-}1}$ ne reçoit pas le signal $D_{in}$ mais reçoit le signal $D_{mix\text{-}b1}$. Le mélangeur 18 comprend, en outre, des transistors MOS $T_{mix2\text{-}2}$ et $T_{mix2\text{-}3}$ à canal N, montés en parallèle entre le noeud B et le noeud C. La grille du transistor $T_{mix2\text{-}2}$ reçoit le signal $D_{mix\text{-}b2}$ et la grille du transistor $T_{mix2\text{-}3}$ reçoit le signal $D_{mix\text{-}b3}$.

Les transistors $T_{mix2-1}$, $T_{mix2-2}$ et $T_{mix2-3}$ fonctionnent comme des interrupteurs. En fonctionnement, le signal $V_{mix-Amin}$ est maintenu constant. Le transistor $T_{mix2-0}$ est donc passant en permanence. Les signaux $D_{mix-b1}$, $D_{mix-b2}$, et $D_{mix-b3}$ peuvent être égaux chacun à "0" ou "1".

Etant donné que les transistors $T_{mix2-0}$, $T_{mix2-1}$, $T_{mix2-2}$ et $T_{mix2-3}$ sont montés en parallèle, le gain de mélange $G_{mix}$ peut s'exprimer selon les relations (8) suivantes :

$$G_{mix}=\begin{cases} G_{mix}^{00} = G_{T_{mix2-0}}^{V_{mix-Amin}}, & D_{in\text{-}less}="0", D_{in\text{-}most}="0" \\[2ex] G_{mix}^{01} = G_{T_{mix2-0}}^{V_{mix-Amin}}+G_{T_{mix2-1}}^{1}, & D_{in\text{-}less}="0", D_{in\text{-}most}="1" \\[2ex] G_{mix}^{10} = G_{T_{mix2-0}}^{V_{mix-Amin}}+G_{T_{mix2-1}}^{1}+G_{T_{mix2-2}}^{1}, & D_{in\text{-}less}="1", D_{in\text{-}most}="0" \\[2ex] G_{mix}^{11} = G_{T_{mix2-0}}^{V_{mix-Amin}}+G_{T_{mix2-1}}^{1}+G_{T_{mix2-2}}^{1}+G_{T_{mix2-3}}^{1}, & D_{in\text{-}less}="1", D_{in\text{-}most}="1" \end{cases} \quad (8)$$

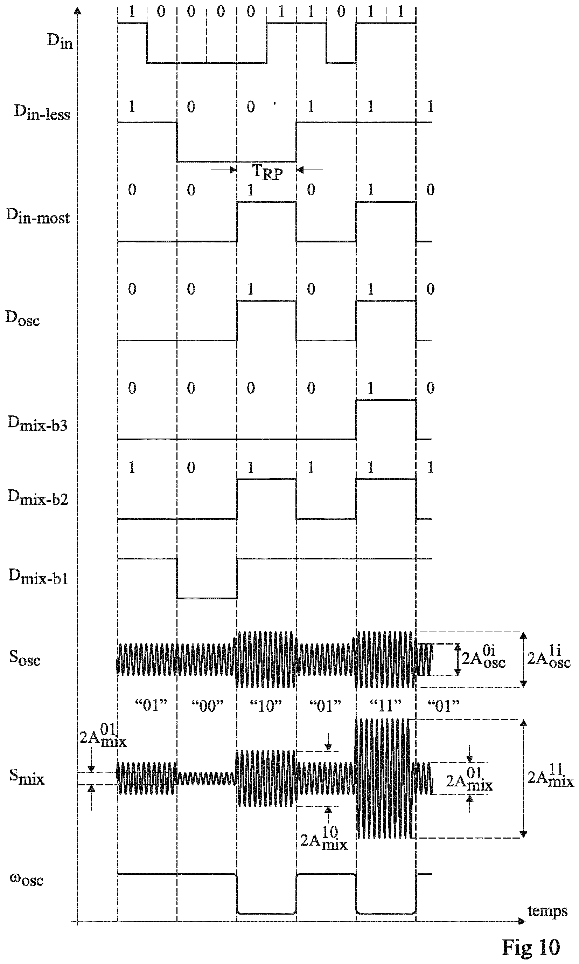

La figure 10 représente un chronogramme des signaux binaires $D_{in}$, $D_{in\text{-}less}$, $D_{in\text{-}most}$, $D_{osc}$, $D_{mix-b3}$, $D_{mix-b2}$, $D_{mix-b1}$, du signal analogique $S_{osc}$, du signal analogique $S_{mix}$ et de la pulsation $\omega_{osc}$. Le système d'émission radiofréquence 50 réalise une modulation FSK sur deux niveaux et une modulation ASK sur quatre niveaux.

La taille de l'interrupteur $T_{mix2-0}$ et la valeur de $V_{mix-Amin}$ définissent la valeur de l'amplitude $A_{mix}^{00}$. Le rapport des tailles des interrupteurs $T_{mix2-1}$ et $T_{mix2-0}$ définit le rapport de modulation entre les symboles "01" et "00", c'est-à-dire le rapport $A_{mix}^{01}/A_{mix}^{00}$. Le rapport des tailles des interrupteurs $T_{mix2-2}$ et $T_{mix2-1}$ définit le rapport de modulation entre les symboles "10" et "01", c'est-à-dire le rapport $A_{mix}^{10}/A_{mix}^{01}$. Le rapport des tailles des interrupteurs $T_{mix2-3}$ et $T_{mix2-2}$ définit le rapport de modulation entre les symboles "11" et "10", c'est-à-dire le rapport $A_{mix}^{11}/A_{mix}^{10}$.

Comme cela est décrit par la suite, l'oscillateur 12 et le mélangeur 18 du système d'émission radiofréquence 50 sont cadencés à la fréquence $F_{RP}$ comme le système d'émission radiofréquence 10 alors que la fréquence de transmission du signal $D_{in}$ est $2F_{RP}$.

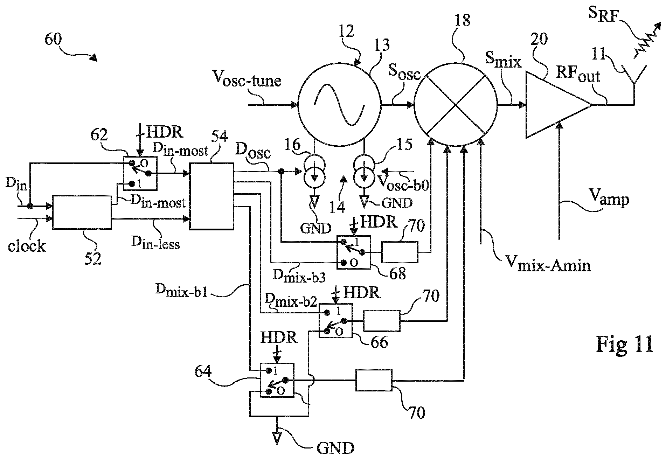

La figure 11 représente un autre mode de réalisation d'un système d'émission radiofréquence UWB 60 adapté à fonctionner à un premier débit de transmission ou à un deuxième débit de transmission égal au double du premier débit de transmission.

Le système d'émission radiofréquence UWB 60 comprend l'ensemble des éléments du système d'émission radiofréquence 50 représenté en figure 8 et comprend, en outre, plusieurs multiplexeurs 62, 64, 66, 68. Chaque multiplexeur 62, 64, 66, 68 reçoit un premier signal à une première entrée et un deuxième signal à une deuxième entrée et reçoit, en outre, un signal binaire de commande HDR. Chaque multiplexeur 62, 64, 66, 68 transmet, en sortie, le premier signal lorsque le signal de commande est à "0" et transmet, en sortie, le deuxième signal lorsque le signal de commande est à "1". Le multiplexeur 62 reçoit le signal $D_{in}$ à la première entrée et le signal $D_{in\text{-}most}$ à la deuxième entrée. Le multiplexeur 64 reçoit le signal "0" à la première entrée et le signal $D_{mix-b1}$ à la deuxième entrée. Le multiplexeur 66 reçoit le signal "0" à la première entrée et le signal $D_{mix-b2}$ à la deuxième entrée. Le multiplexeur 68 reçoit le signal $D_{osc}$ à la première entrée et le signal $D_{mix-b3}$ à la deuxième entrée. Des modules de temporisation 70 peuvent être prévus, si cela est nécessaire, en sortie des multiplexeurs 64, 66 et 68.

Lorsque le signal HDR est à "0", le système d'émission radiofréquence 60 est équivalent au système d'émission radiofréquence 10 représenté en figure 1 et peut fonctionner à un premier débit de transmission. Lorsque le signal HDR est à "1", le système d'émission radiofréquence 60 est équivalent au système d'émission radiofréquence 50 représenté en figure 8 et peut fonctionner à un deuxième débit de transmission égal au double du premier débit.

Des modes de réalisation particuliers ont été décrits. Diverses variantes et modifications apparaîtront à l'homme de l'art. En particulier, bien que des modes de réalisation aient été décrits dans lesquels la modulation ASK est réalisée sur deux niveaux d'amplitude ou quatre niveaux d'amplitude, il est clair que le nombre de niveaux d'amplitude de la modulation ASK peut être différent. En effet, selon les modes de réalisation décrits précédemment, le nombre de niveaux d'amplitude de la modulation ASK peut être ajusté en modifiant le nombre de transistors et leurs rapports de tailles respectives montés en parallèle entre les noeuds B et C dans le mélangeur 18. En outre, bien que des modes de réalisation aient été décrits dans lesquels la modulation FSK est réalisée sur deux niveaux de fréquence, il est clair que le nombre de niveaux de fréquence de la modulation FSK peut être différent. En effet, selon les modes de réalisation décrits précédemment, le nombre de niveaux de fréquence de la modulation FSK peut être ajusté en modifiant le nombre de sources de courant montées en parallèle du circuit d'alimentation 14 du VCO 12.

**Revendications**

1. Système d'émission radiofréquence ultra large bande (10 ; 50 ; 80) adapté à recevoir un premier signal à niveaux discrets ($D_{in}$), et comprenant :

   un oscillateur commandé en tension (12) adapté à fournir un premier signal oscillant ($S_{osc}$) comportant un circuit oscillant (13) alimenté par un circuit d'alimentation (14) comportant au moins une première source de courant (16) commandée par le premier signal à niveaux discrets ou un deuxième signal à niveaux discrets ($D_{osc}$) obtenu à partir du premier signal à niveaux discrets,
   un mélangeur (18) adapté à recevoir le premier signal oscillant et à fournir un deuxième signal oscillant ($S_{mix}$) égal au premier signal oscillant ($S_{osc}$) multiplié par un gain qui dépend du premier signal à niveaux discrets ($D_{in}$) ou d'un troisième signal à niveaux discrets ($D_{mix-b1}$, $D_{mix-b2}$, $D_{mix-b3}$) obtenu à partir du premier signal à niveaux discrets ; et
   une antenne ou un dispositif de couplage électromagnétique (11) adapté à émettre un signal radiofréquence ($S_{RF}$) à partir du deuxième signal oscillant.

2. Système d'émission radiofréquence selon la revendication 1, dans lequel l'oscillateur commandé en tension (12) est adapté à fournir le premier signal oscillant ($S_{osc}$) à une première fréquence d'oscillation lorsque le premier signal à niveaux discrets ($D_{in}$) ou le deuxième signal à niveaux discrets ($D_{osc}$) est à un premier état et à fournir le premier signal oscillant ($S_{osc}$) à une deuxième fréquence d'oscillation, différente de la première fréquence d'oscillation, lorsque le premier signal à niveaux discrets ($D_{in}$) ou le deuxième signal à niveaux discrets ($D_{osc}$) est à un deuxième état.

3. Système d'émission radiofréquence selon la revendication 2, dans lequel la première source de courant (16) est activée lorsque le premier signal à niveaux discrets ($D_{in}$) ou le deuxième signal à niveaux discrets ($D_{osc}$) est au premier état et est désactivée lorsque le premier signal à niveaux discrets ou le deuxième signal à niveaux discrets est au deuxième état.

4. Système d'émission radiofréquence selon l'une quelconque des revendications 1 à 3, dans lequel le circuit d'alimentation (14) comporte une deuxième source de courant (15) activée en permanence en parallèle de la première source de courant (16).

5. Système d'émission radiofréquence selon l'une quelconque des revendications 1 à 4, comprenant un module de conversion série/parallèle (52) adapté à recevoir le premier signal à niveaux discrets ($D_{in}$) à une première fréquence et adapté à fournir au moins des quatrième et cinquième signaux à niveaux discrets ($D_{in-less}$, $D_{in-most}$) à une deuxième fréquence inférieure à la première fréquence et comprenant un module de logique combinatoire adapté à recevoir les quatrième et cinquième signaux à niveaux discrets et adapté à fournir le deuxième signal à niveaux discrets ($D_{osc}$) et le troisième signal à niveaux discrets ($D_{mix-b1}$, $D_{mix-b2}$, $D_{mix-b3}$).

6. Système d'émission radiofréquence selon l'une quelconque des revendications 1 à 5, dans lequel le mélangeur (18) comprend un amplificateur à transconductance ($T_{mix1}$) adapté à recevoir le premier signal oscillant ($S_{osc}$) et comprenant une sortie reliée à un noeud (C), adapté à fournir le deuxième signal oscillant ($S_{mix}$), par au moins un premier interrupteur ($T_{mix2-1}$) commandé par le premier signal à niveaux discrets ($D_{in}$) ou le troisième signal à niveaux discrets ($D_{mix-b1}$).

7. Système d'émission radiofréquence selon la revendication 6, dans lequel le mélangeur (18) comprend au moins un deuxième interrupteur ($T_{mix2-2}$) monté en parallèle du premier interrupteur ($T_{mix2-1}$) et commandé par un sixième signal à niveaux discrets ($D_{mix-b2}$, $D_{mix-b3}$) obtenu à partir du premier signal à niveaux discrets ($D_{in}$).

8. Système d'émission radiofréquence selon la revendication 6 ou 7, dans lequel le mélangeur (18) comprend au moins un troisième interrupteur ($T_{mix2-0}$) monté en parallèle du premier interrupteur ($T_{mix2-1}$) et commandé par un signal de commande analogique ($V_{mix-Amin}$) constant.

**9.** Procédé d'émission radiofréquence ultra large bande comprenant les étapes suivantes :

recevoir un premier signal à niveaux discrets ($D_{in}$) ;
fournir un premier signal oscillant ($S_{osc}$) par un oscillateur commandé en tension (12) comportant un circuit oscillant (13) alimenté par un circuit d'alimentation (14) comportant au moins une première source de courant (16) commandée par le premier signal à niveaux discrets ou un deuxième signal à niveaux discrets ($D_{osc}$) obtenu à partir du premier signal à niveaux discrets ;
fournir un deuxième signal oscillant ($S_{mix}$), par un mélangeur (18), égal au premier signal oscillant ($S_{osc}$) multiplié par un gain qui dépend du premier signal à niveaux discrets ($D_{in}$) ou d'un troisième signal à niveaux discrets ($D_{mix-b1}$, $D_{mix-b2}$, $D_{mix-b3}$) obtenu à partir du premier signal à niveaux discrets ; et
émettre un signal radiofréquence ($S_{RF}$) à partir du deuxième signal oscillant par une antenne (11) ou un dispositif de couplage électromagnétique.

**10.** Procédé d'émission radiofréquence selon la revendication 9, dans lequel l'oscillateur commandé en tension (12) fournit le premier signal oscillant ($S_{osc}$) à une première fréquence d'oscillation lorsque le premier signal à niveaux discrets ($D_{in}$) ou le deuxième signal à niveaux discrets ($D_{osc}$) est à un premier état et fournit le premier signal oscillant ($S_{osc}$) à une deuxième fréquence d'oscillation, différente de la première fréquence d'oscillation, lorsque le premier signal à niveaux discrets ($D_{in}$) ou le deuxième signal à niveaux discrets ($D_{osc}$) est à un deuxième état.

**Patentansprüche**

**1.** Ein Ultrabreitband-Hochfrequenz-Übertragungssystem (10; 50; 80), das geeignet ist zum Empfangen eines ersten Signals mit diskreten Niveaus ($D_{in}$), und das Folgendes aufweist:

einen spannungsgesteuerten Oszillator (12), der geeignet ist zum Bereitstellen eines ersten oszillierenden Signals ($S_{OSC}$) mit einem Schwingkreis (13), der durch eine Versorgungsschaltung (14) mit wenigstens einer ersten Stromquelle (16) betrieben wird, die durch das erste Signal mit diskreten Niveaus oder einem zweiten Signal mit diskreten Niveaus ($D_{OSC}$), das aus den ersten Signalen mit diskreten Niveaus erhalten wird, gesteuert wird;
einen Mischer (18), der geeignet ist zum Empfangen des ersten oszillierenden Signals und zum Bereitstellen eines zweiten oszillierenden Signals ($S_{mix}$), das gleich ist zu dem ersten oszillierenden Signal ($S_{OSC}$) multipliziert mit einem Verstärkungsfaktor, der von dem ersten Signal mit diskreten Niveaus ($D_{in}$) oder von einem dritten Signal mit diskreten Niveaus ($D_{mix-b1}$, $D_{mix-b2}$, $D_{mix-b3}$) abhängt, das von dem ersten Signal mit diskreten Niveaus erhalten wird; und
eine Antenne oder eine elektromagnetische Kopplungsvorrichtung (11), die geeignet ist zum Übertragen eines Hochfrequenzsignals ($S_{RF}$) basierend auf dem zweiten oszillierenden Signal.

**2.** Hochfrequenz-Übertragungssystem nach Anspruch 1, wobei der spannungsgesteuerte Oszillator (12) geeignet ist zum Bereitstellen des ersten oszillierenden Signals ($S_{OSC}$) mit einer ersten Oszillationsfrequenz, wenn sich das erste Signal mit diskreten Niveaus ($D_{in}$) oder das zweite Signal mit diskreten Niveaus ($D_{OSC}$) in einem ersten Zustand befindet, und zum Bereitstellen des ersten oszillierenden Signals ($S_{OSC}$) mit einer zweiten Oszillationsfrequenz, die sich von der ersten Oszillationsfrequenz unterscheidet, wenn sich das erste Signal mit diskreten Niveaus ($D_{in}$) oder das zweite Signal mit diskreten Niveaus ($D_{OSC}$) in einem zweiten Zustand befindet.

**3.** Hochfrequenz-Übertragungssystem nach Anspruch 2, wobei die erste Stromquelle (16) aktiviert wird, wenn sich das erste Signal mit diskreten Niveaus ($D_{in}$) oder das zweite Signal mit diskreten Niveaus ($D_{OSC}$) in dem ersten Zustand befindet und deaktiviert wird, wenn sich das erste Signal mit diskreten Niveaus oder das zweite Signal mit diskreten Niveaus in dem zweiten Zustand befindet.

**4.** Hochfrequenz-Übertragungssystem nach einem der Ansprüche 1 bis 3, wobei der Versorgungsschaltung (14) eine zweite permanent aktivierte Stromquelle (15) parallel geschaltet mit der ersten Stromquelle (16) aufweist.

**5.** Hochfrequenz-Übertragungssystem nach einem der Ansprüche 1 bis 4, das eine Reihen-Parallel-Umwandlungseinheit (52) aufweist, die geeignet ist zum Empfangen des ersten Signals mit diskreten Niveaus ($D_{in}$) mit einer ersten Frequenz, und geeignet zum Bereitstellen wenigstens vierter und fünfter Signale mit diskreten Niveaus ($D_{in-less}$, $D_{in-most}$) mit einer zweiten Frequenz, die niedriger ist als die erste Frequenz, und die eine kombinatorische Logikeinheit aufweist, die geeignet ist zum Empfangen der vierten und fünften Signale mit diskreten Niveaus ($D_{OSC}$)

und des dritten Signals mit diskreten Niveaus und zum Bereitstellen des zweiten Signals mit diskreten Niveaus ($D_{mix-b1}$, $D_{mix-b2}$, $D_{mix-b3}$).

6. Hochfrequenz-Übertragungssystem nach einem der Ansprüche 1 bis 5, wobei der Mischer (18) einen Transkonduktanz-Verstärker ($T_{mix1}$) aufweist, der geeignet ist zum Empfangen des ersten oszillierenden Signals ($S_{OSC}$), und der einen mit einem Knotenpunkt (C) verbunden Ausgang aufweist, der geeignet ist zum Bereitstellen des zweiten oszillierenden Signals ($S_{mix}$) von wenigstens einem ersten Schalter ($T_{mix2-1}$), der durch das erste Signal mit diskreten Niveaus ($D_{in}$) oder durch das dritte Signal mit diskreten Niveaus ($D_{mix-b1}$) gesteuert wird.

7. Hochfrequenz-Übertragungssystem nach Anspruch 6, wobei der Mischer (18) wenigstens einen zweiten Schalter ($T_{mix2-2}$) aufweist, der parallel mit dem ersten Schalter ($T_{mix2-1}$) angeordnet ist, und durch ein sechstes Signal mit diskreten Niveaus ($D_{mix-b2}$, $D_{mix-b3}$) gesteuert wird, das von dem ersten Signal mit diskreten Niveaus ($D_{in}$) erhalten wird.

8. Hochfrequenz-Übertragungssystem nach Anspruch 6 oder 7, wobei der Mischer (18) wenigstens einen dritten Schalter ($T_{mix2-0}$) aufweist, der parallel mit dem ersten Schalter ($T_{mix2-1}$) angeordnet ist, und durch ein konstantes analoges Steuersignal ($V_{mix-Amin}$) gesteuert wird.

9. Ein Ultrabreitband-Hochfrequenz-Übertragungsverfahren, das die folgenden Schritte aufweist:

Empfangen eines ersten Signals mit diskreten Niveaus ($D_{in}$);
Bereitstellen eines ersten oszillierenden Signals ($S_{OSC}$) mittels eines spannungsgesteuerten Oszillators (12) mit einem Schwingkreis (13), der durch eine Versorgungsschaltung (14) mit wenigstens einer ersten Stromquelle (16) betrieben wird, die durch das erste Signal mit diskreten Niveaus oder einem zweiten Signal mit diskreten Niveaus ($D_{OSC}$) gesteuert wird, das von den ersten Signalen mit diskreten Niveaus erhalten wird;
Bereitstellen eines zweiten oszillierenden Signals ($S_{mix}$) mittels eines Mischers (18), das gleich ist zu dem ersten oszillierenden Signal ($S_{OSC}$) multipliziert mit einem Verstärkungsfaktor, der von dem ersten Signal mit diskreten Niveaus ($D_{in}$) oder von einem dritten Signal mit diskreten Niveaus ($D_{mix-b1}$, $D_{mix-b2}$, $D_{mix-b3}$) abhängt, das von dem ersten Signal mit diskreten Niveaus erhalten wird; und
Übertragen eines Hochfrequenzsignals ($S_{RF}$) basierend auf dem zweiten oszillierenden Signal mittels einer Antenne (11) oder einer elektromagnetischen Kopplungsvorrichtung.

10. Hochfrequenz-Übertragungsverfahren nach Anspruch 9, wobei der spannungsgesteuerte Oszillator (12) das erste oszillierende Signal ($S_{OSC}$) mit einer ersten Oszillationsfrequenz bereitstellt, wenn sich das erste Signal mit diskreten Niveaus ($D_{in}$) oder das zweite Signal mit diskreten Niveaus ($D_{OSC}$) in einem ersten Zustand befindet, und das erste oszillierende Signal ($S_{OSC}$) mit einer zweiten Oszillationsfrequenz, die sich von der ersten Oszillationsfrequenz unterscheidet, bereitstellt, wenn sich das erste Signal mit diskreten Niveaus ($D_{in}$) oder das zweite Signal mit diskreten Niveaus ($D_{OSC}$) in einem zweiten Zustand befindet.

**Claims**

1. An ultra wideband radio frequency transmission system (10; 50; 80) capable of receiving a first signal with discrete levels ($D_{in}$), and comprising:

a voltage-controlled oscillator (12) capable of supplying a first oscillating signal ($S_{osc}$) comprising an oscillating circuit (13) powered by a supply circuit (14) comprising at least one first current source (16) controlled by the first signal with discrete levels or a second signal with discrete levels ($D_{osc}$) obtained from the first signal with discrete levels;
a mixer (18) capable of receiving the first oscillating signal and of supplying a second oscillating signal ($S_{mix}$) equal to the first oscillating signal ($S_{osc}$) multiplied by a gain which depends on the first signal with discrete levels ($D_{in}$) or on a third signal with discrete levels ($D_{mix-b1}$, $D_{mix-b2}$, $D_{mix-b3}$) obtained from the first signal with discrete levels; and
an antenna or an electromagnetic coupling device (11) capable of transmitting a radio frequency signal ($S_{RF}$) based on the second oscillating signal.

2. The radio frequency transmission system of claim 1, wherein the voltage-controlled oscillator (12) is capable of supplying the first oscillating signal ($S_{osc}$) at a first oscillation frequency when the first signal with discrete levels

($D_{in}$) or the second signal with discrete levels ($D_{osc}$) is in a first state and of supplying the first oscillating signal ($S_{osc}$) at a second oscillation frequency, different from the first oscillation frequency, when the first signal with discrete levels ($D_{in}$) or the second signal with discrete levels ($D_{osc}$) is in a second state.

3. The radio frequency transmission system of claim 2, wherein the first current source (16) is activated when the first signal with discrete levels (Din) or the second signal with discrete levels ($D_{osc}$) is in the first state and is deactivated when the first signal with discrete levels or the second signal with discrete levels is in the second state.

4. The radio frequency transmission system of any of claims 1 to 3, wherein the supply circuit (14) comprises a second permanently activated current source (15) in parallel with the first current source (16).

5. The radio frequency transmission system of any of claims 1 to 4, comprising a series-to-parallel conversion unit (52) capable of receiving the first signal with discrete levels ($D_{in}$) at a first frequency and capable of supplying at least fourth and fifth signals with discrete levels ($D_{in-less}$, $D_{in-most}$) at a second frequency lower than the first frequency and comprising a combinational logic unit capable of receiving the fourth and fifth signals with discrete levels and of supplying the second signal with discrete levels ($D_{osc}$) and the third signal with discrete levels ($D_{mix-b1}$, $D_{mix-b2}$, $D_{mix-b3}$).

6. The radio frequency transmission system of any of claims 1 to 5, wherein the mixer (18) comprises a transconductance amplifier ($T_{mix1}$) capable of receiving the first oscillating signal ($S_{osc}$) and comprising an output connected to a node (C), capable of supplying the second oscillating signal ($S_{mix}$), by at least one first switch ($T_{mix2-1}$) controlled by the first signal with discrete levels ($D_{in}$) or the third signal with discrete levels ($D_{mix-b1}$).

7. The radio frequency transmission system of claim 6, wherein the mixer (18) comprises at least one second switch ($T_{mix2-2}$) assembled in parallel with the first switch ($T_{mix2-1}$) and controlled by a sixth signal with discrete levels ($D_{mix-b2}$, $D_{mix-b3}$) obtained from the first signal with discrete levels ($D_{in}$).

8. The radio frequency transmission system of claim 6 or 7, wherein the mixer (18) comprises at least one third switch ($T_{mix2-0}$) assembled in parallel with the first switch ($T_{mix2-1}$) and controlled by a constant analog control signal ($V_{mix-Amin}$).

9. An ultra wideband radio frequency transmission method comprising the steps of:

receiving a first signal with discrete levels ($D_{in}$) ;
supplying a first oscillating signal ($S_{osc}$) by means of a voltage-controlled oscillator (12) comprising an oscillating circuit (13) powered by a supply circuit (14) comprising at least one first current source (16) controlled by the first signal with discrete levels or a second signal with discrete levels ($D_{osc}$) obtained from the first signal with discrete levels;
supplying a second oscillating signal ($S_{mix}$), by means of a mixer (18), equal to the first oscillating signal ($S_{osc}$) multiplied by a gain which depends on the first signal with discrete levels ($D_{in}$) or on a third signal with discrete levels ($D_{mix-b1}$, $D_{mix-b2}$, $D_{mix-b3}$) obtained from the first signal with discrete levels; and
transmitting a radio frequency signal ($S_{RF}$) based on the second oscillating signal by means of an antenna (11) or an electromagnetic coupling device.

10. The radio frequency transmission method of claim 9, wherein the voltage-controlled oscillator (12) supplies the first oscillating signal ($S_{osc}$) at a first oscillation frequency when the first signal with discrete levels ($D_{in}$) or the second signal with discrete levels ($D_{osc}$) is in a first state and supplies the first oscillating signal ($S_{osc}$) at a second oscillation frequency, different from the first oscillation frequency, when the first signal with discrete levels ($D_{in}$) or the second signal with discrete levels ($D_{osc}$) is in a second state.

Fig 1

Fig 2

Fig 3

Fig 4

Fig 5

Fig 6

Fig 7

Fig 8

Fig 9

EP 3 079 320 B1

Fig 10

Fig 11

## RÉFÉRENCES CITÉES DANS LA DESCRIPTION

**Documents brevets cités dans la description**

- WO 2008069444 A
- US 2004017841 A